# EUROPEAN PATENT APPLICATION

(11) **EP 4 804 784 A1**
(43) Date of publication of application: **09.09.2026**
(21) Application number: 25221065.3
(22) Date of filing: 05.12.2025
(51) Int. Cl.: H10W 72/20

(54) **INTEGRATED CIRCUIT PACKAGE INCLUDING A SUBSTRATE WITH PACKAGE SUBSTRATE SIDE CONDUCTIVE CONTACTS FIRST APPROACH**

(30) Priority: 04.03.2025 US 202519069455
(71) Applicant: Intel Corporation, Santa Clara, CA 95054 (US)
(72) Inventor: WAIMIN, Jose, Chandler, 85226 (US); CARRAZZONE, Ryan, Chandler, 85226 (US); FENG, Hongxia, Chandler, 85249 (US); LIU, Boer, Tempe, 85288 (US)
(74) Representative: 2SPL Patentanwälte PartG mbB

(57) **Abstract**

Accordingly, substrates for multi-die IC packages, and related assemblies, devices and methods, are disclosed herein. For example, in some embodiments, a substrate may include a dielectric material having a first surface and an opposing second surface, wherein the first surface includes a protruding portion; a conductive contact on the protruding portion of the first surface of the dielectric material; and a conductive pathway through the dielectric material and coupled to the conductive pathway. In some embodiments, the protruding portion of the first surface of the dielectric material has a thickness between 3 microns and 10 microns.

## Description

### Background

Integrated circuit (IC) devices (e.g., dies) are typically coupled together in a multi-die IC package to integrate features or functionality and to facilitate connections to other components, such as package substrates.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a side, cross-sectional view of an example microelectronic assembly, in accordance with various embodiments.
FIG. 2A is a simplified side, cross-sectional view of the microelectronic assembly of FIG. 1, in accordance with various embodiments.
FIG. 2B is a side, cross-sectional view of a portion of the microelectronic assembly of FIG. 1, in accordance with various embodiments.
FIG. 3A is a side, cross-sectional view of another example microelectronic assembly, in accordance with various embodiments.
FIG. 3B is a side, cross-sectional view of another example microelectronic assembly, in accordance with various embodiments.
FIGS. 4A-4K are side, cross-sectional views of various stages in an example process for manufacturing a microelectronic assembly, in accordance with various embodiments.
FIG. 5 is a flowchart of an exemplary method for fabricating a microelectronic assembly, in accordance with various embodiments.
FIG. 6 is a cross-sectional view of a device package that includes one or more microelectronic assemblies in accordance with any of the embodiments disclosed herein.
FIG. 7 is a cross-sectional side view of a device assembly that includes one or more microelectronic assemblies in accordance with any of the embodiments disclosed herein.
FIG. 8 is a block diagram of an example computing device that includes one or more microelectronic assemblies in accordance with any of the embodiments disclosed herein.

### Detailed Description

For the past several decades, scaling of features in integrated circuits (ICs) has been a driving force behind an ever-growing semiconductor industry and emerging applications in fields such as big data, artificial intelligence, mobile communications, and autonomous driving. Multiple IC dies are now commonly coupled together in a multi-die IC package to integrate features or functionality and to facilitate connections to other components, such as package substrates. For example, IC packages may include an embedded multi-die interconnect bridge (EMIB), also referred to herein as a "bridge," "bridge die," or "interconnect die," for providing more localized horizontal high-density signal transmission between two or more IC dies and conductive pillars for providing more direct vertical transmission from the package substrate to the IC dies.

Multi-die IC packages may be electrically coupled to a package substrate by interconnects that include conductive contacts at a surface of the multi-die IC package, also referred to herein as "package substrate side conductive contacts." During manufacturing, forming package substrate side conductive contacts first has tremendous benefits but adds significant complexity. Traditionally, a manufacturing flow for creating package substrate side conductive contacts first in a multi-die IC package involves forming conductive contacts on a carrier, encapsulating the surface conductive contacts in a protective material, performing subsequent assembly processes, detaching the carrier, and removing the protective material to reveal the package substrate side conductive contacts that protrude from the surface of the multi-die IC package. The protective material generally includes an adhesive that effectively covers and shields the package substrate side conductive contacts throughout the manufacturing process and that, subsequently, may be removed, for example, by a solvent. However, such solvents are costly and typically require a long period of time to remove the adhesive. Further, these cleaner solvents are harsh and may negatively impact other materials and interfaces in the multi-die IC package. The IC packages disclosed herein may achieve a process for forming package substrate side conductive contacts first by using a heat-resistant photoresist material that may be readily removed without adding manufacturing complexity or increasing potential damage to the IC package by exposure to a cleaner solvent.

Accordingly, substrates for multi-die IC packages, and related assemblies, devices and methods, are disclosed herein. For example, in some embodiments, a substrate may include a dielectric material having a first surface and an opposing second surface, wherein the first surface includes a protruding portion; a conductive contact on the protruding portion of the first surface of the dielectric material; and a conductive pathway through the dielectric material and coupled to the conductive pathway. In some embodiments, the protruding portion of the first surface of the dielectric material has a thickness between 3 microns and 10 microns.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may include substantially monocrystalline semiconductors, such as silicon or germanium, as a base material (e.g., substrate, body) on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a silicon-on-insulator (SOI) structure. In some other embodiments, the base material of one or more of the IC dies may include alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may include compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may include an intrinsic IV or III-V semiconductor material or alloy, not intentionally doped with any electrically active impurity; in alternate embodiments, nominal impurity dopant levels may be present. In still other embodiments, dies may include a non-crystalline material, such as polymers; for example, the base material may include silica-filled epoxy. In other embodiments, the base material may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of I/O functions, arithmetic operations, pipelining of data, etc.).

In another example, the terms "package" and "IC package" are synonymous, as are the terms "die" and "IC die." Note that the terms "chip," "die," and "IC die" are used interchangeably herein.

The term "optical structure" includes arrangements of forms fabricated in ICs to receive, transform and/or transmit optical signals as described herein. It may include optical conductors such as waveguides, electromagnetic radiation sources such as lasers and light-emitting diodes (LEDs) and electro-optical devices such as photodetectors.

In various embodiments, any photonic IC (PIC) described herein may include a semiconductor material, for example, N-type or P-type materials. The PIC may include, for example, a crystalline base material formed using a bulk silicon (or other bulk semiconductor material) or a SOI structure (or, in general, a semiconductor-on-insulator structure). In some embodiments, the PIC may be formed using alternative materials, which may or may not be combined with silicon, that include, but are not limited to, lithium niobite, indium phosphide, silicon dioxide, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-N or group IV materials. In some embodiments, the PIC may include a non-crystalline material, such as polymers. In some embodiments, the PIC may be formed on a printed circuit board (PCB). In some embodiments, the PIC may be inhomogeneous, including a carrier material (such as glass or silicon carbide) as a base material with a thin semiconductor layer over which is an active side comprising transistors and like components. Although a few examples of the material for the PIC are described here, any material or structure that may serve as a foundation upon which the PIC may be built falls within the spirit and scope of the present disclosure.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" or "insulator" (also called herein as "dielectric material" or "dielectric") refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon, silicon oxide, silicon carbide, silicon carbonitride, silicon nitride, and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., MOSFETs. In many embodiments, an FET is a four-terminal device. In silicon-on-insulator, or nanoribbon, or gate all-around (GAA) FET, the FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are included in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a PIC, "interconnect" may also describe any element formed of a material that is optically conductive for providing optical connectivity to one or more elements associated with the PIC. In such cases, the term "interconnect" may refer to optical waveguides, including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (e.g., silicon dioxide or SiO₂), borosilicate (e.g., 70-80 wt% SiO₂, 7-13 wt% of B₂O₃, 4-8 wt% Na₂O or K₂O, and 2-8 wt% of Al₂O₃) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material includes interlayer low-k dielectric that is provided within the IC die. Within package substrates, and PCBs such insulating material includes organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

In context of a stack of dies coupled to one another or in context of a die coupled to a package substate, the term "interconnect" may also refer to, respectively, die-to-die (DTD) interconnects and die-to-package substrate (DTPS) interconnects. DTD interconnects may also be referred to as first-level interconnects (FLI). DTPS interconnects may also be referred to as Second-Level Interconnects (SLI). Although not specifically shown in all of the present illustrations in order to not clutter the drawings, when DTD or DTPS interconnects are described, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the DTD or DTPS interconnects. In some embodiments, the pitch of the DTD interconnects may be different from the pitch of the DTPS interconnects, although, in other embodiments, these pitches may be substantially the same.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may include the same or different insulating materials. In some embodiments, the levels of underfill may include thermoset epoxies with silicon oxide particles; in some embodiments, the levels of underfill may include any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed on, over, or under another layer may be directly in contact with the other layer or may have one or more intervening layers. Moreover, one layer disposed between two layers may be directly in contact with one or both of the two layers or may have one or more intervening layers. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

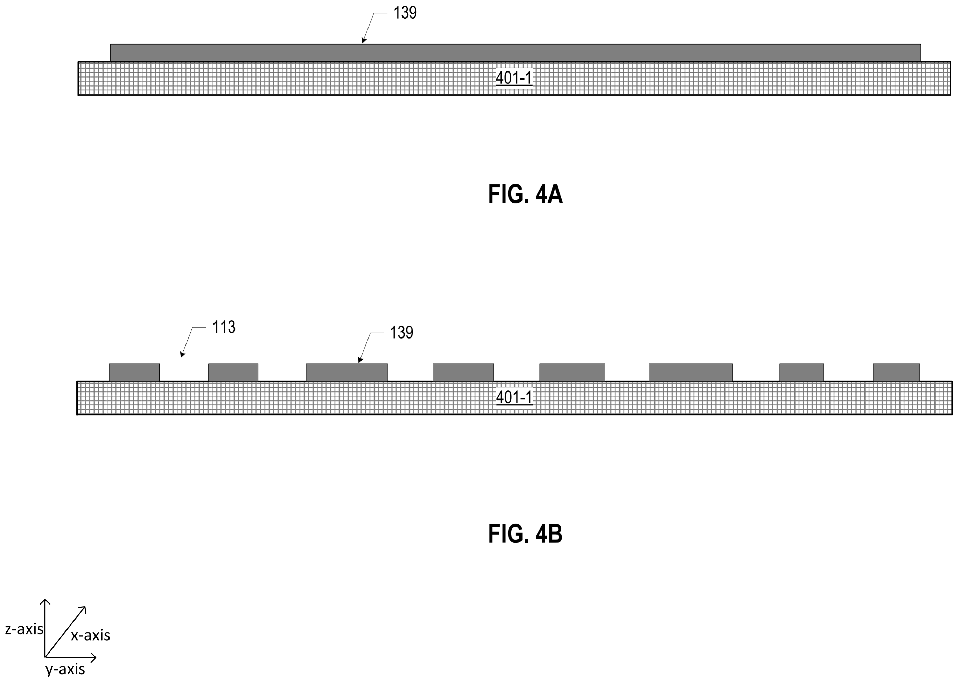

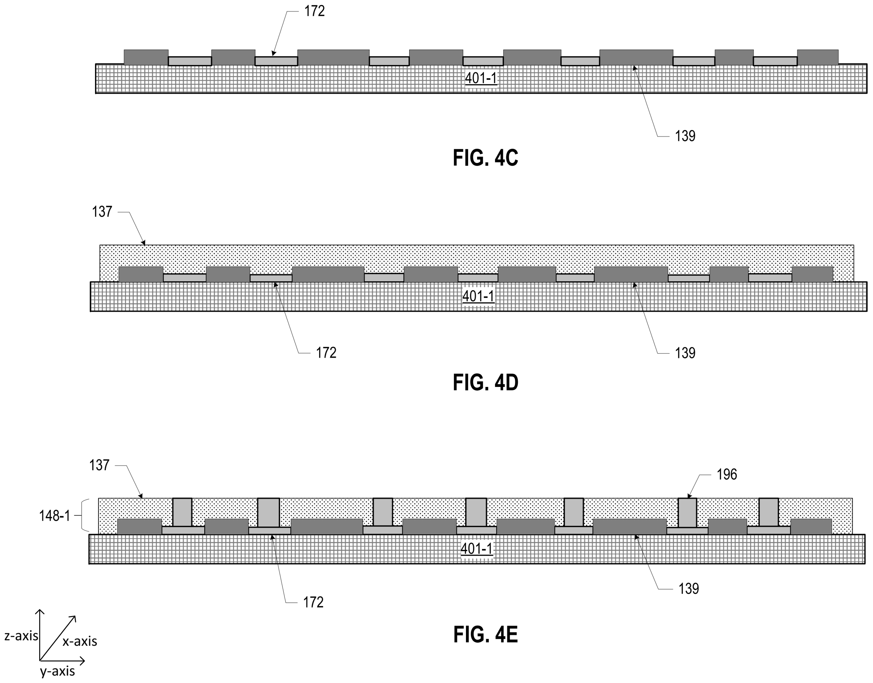

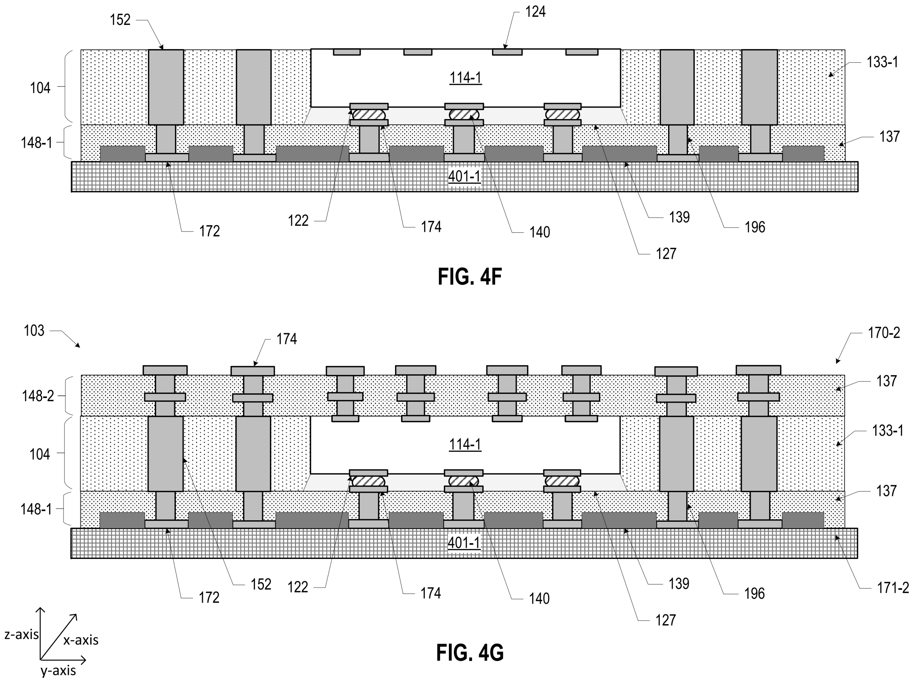

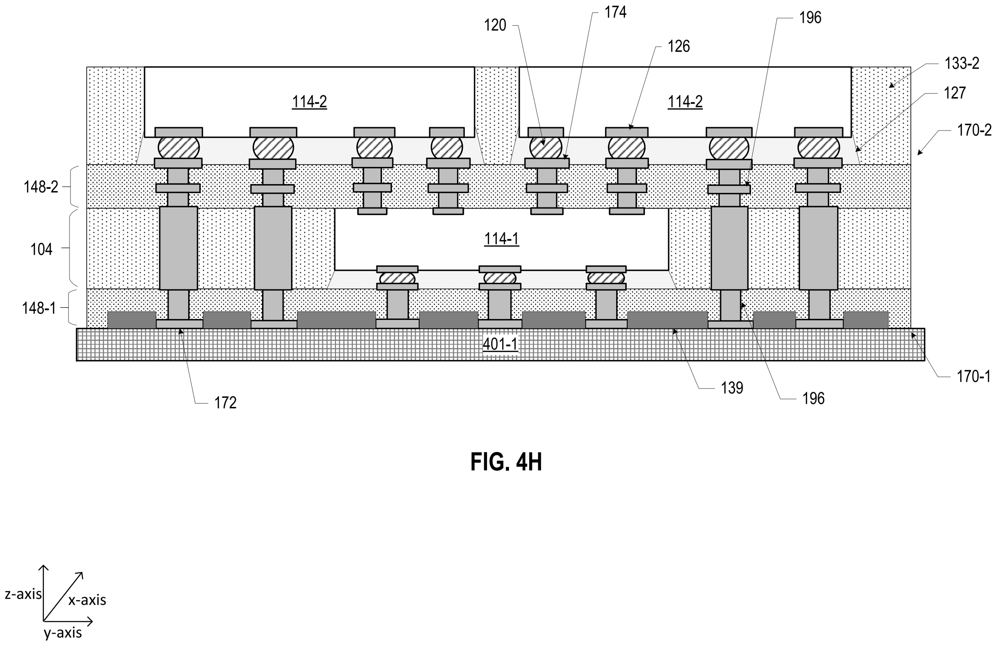

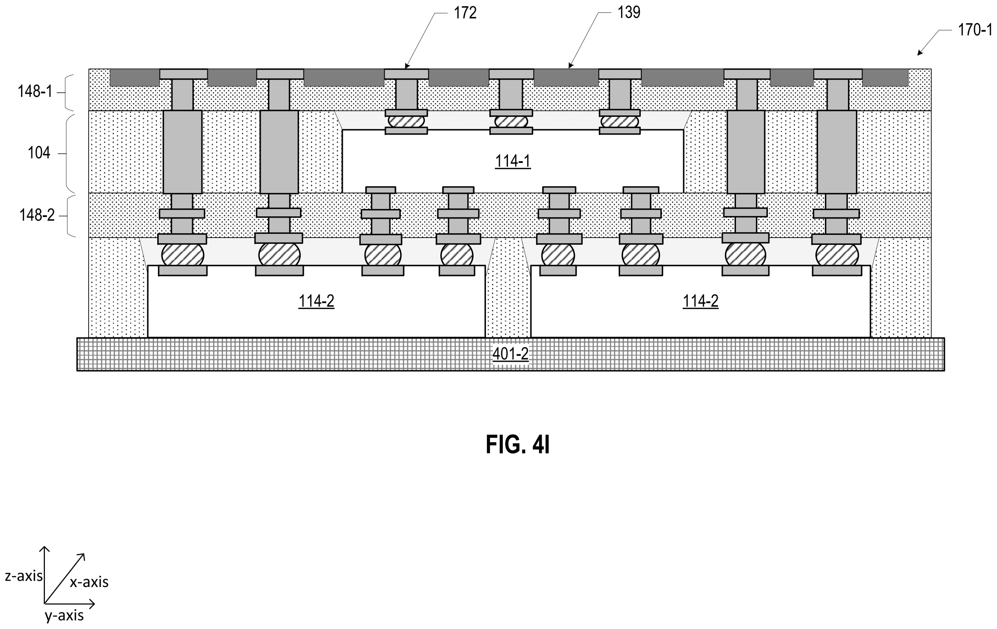

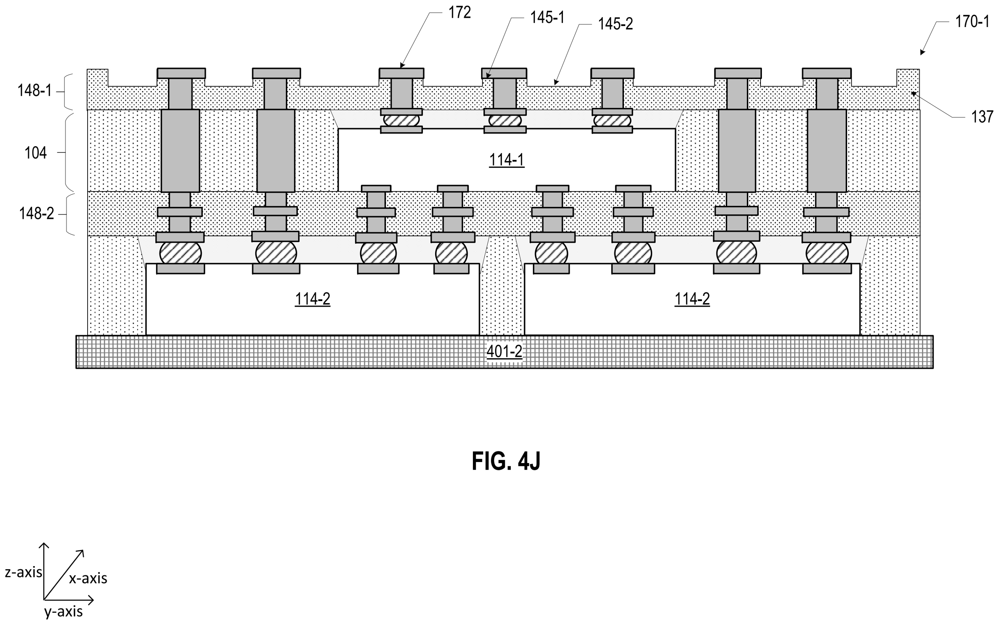

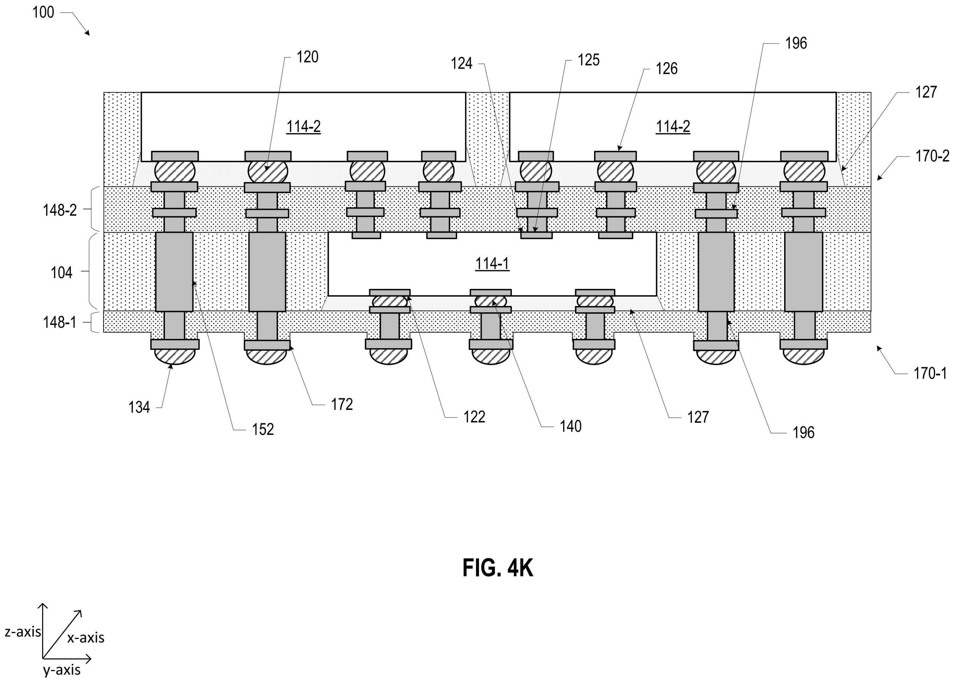

For convenience, if a collection of drawings designated with different letters are present (e.g., FIGS. 4A-4K), such a collection may be referred to herein without the letters (e.g., as "FIG. 4"). Similarly, if a collection of reference numerals designated with different numbers are present (e.g., 148-1, 148-2), such a collection may be referred to herein without the numbers (e.g., as "148")*.*

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

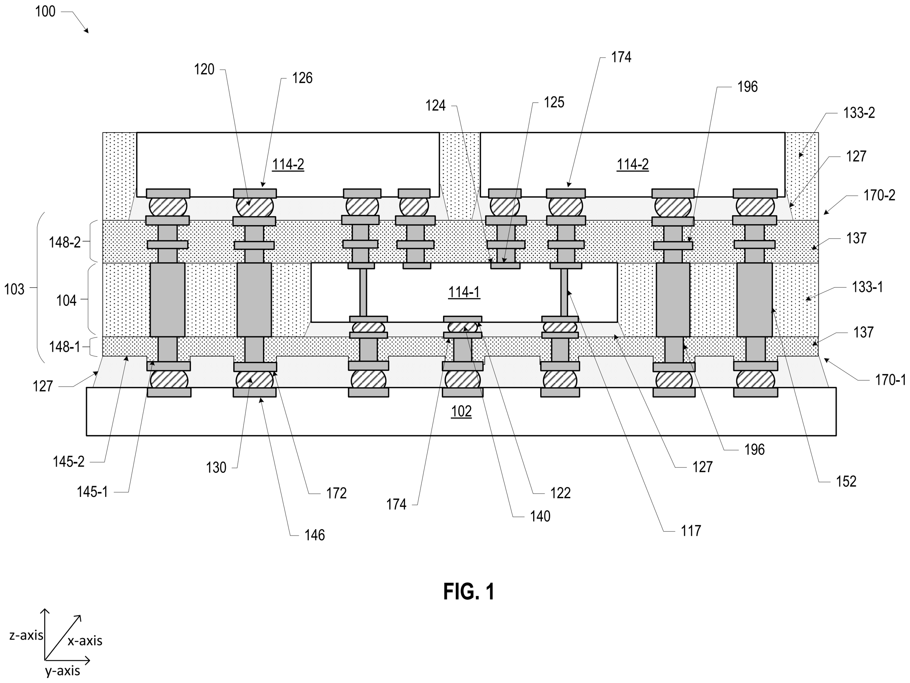

FIG. 1 is a side, cross-sectional view of an example microelectronic assembly, in accordance with various embodiments. The microelectronic assembly 100 may include a substrate 103 having a first major side 170-1 having a stepped contour and an opposing second major side 170-2, a package substrate 102 electrically coupled to the first major side 170-1 of the substrate 103, and second layer dies 114-2 electrically coupled to the second major side 170-2 of the substrate 103. In some embodiments, the substrate 103 may include multiple layers, for example, a layer 104 of dies 114 between redistribution layers (RDLs) 148. As shown in FIG. 1, a substrate 103 may include a layer 104 having first layer die 114-1 (e.g., also referred to herein as bridge die) and conductive pillars 152 surrounded by a first insulating material 133-1, a first RDL 148-1 at a bottom surface of the layer 104, and a second RDL 148-2 at a top surface of the layer 104.

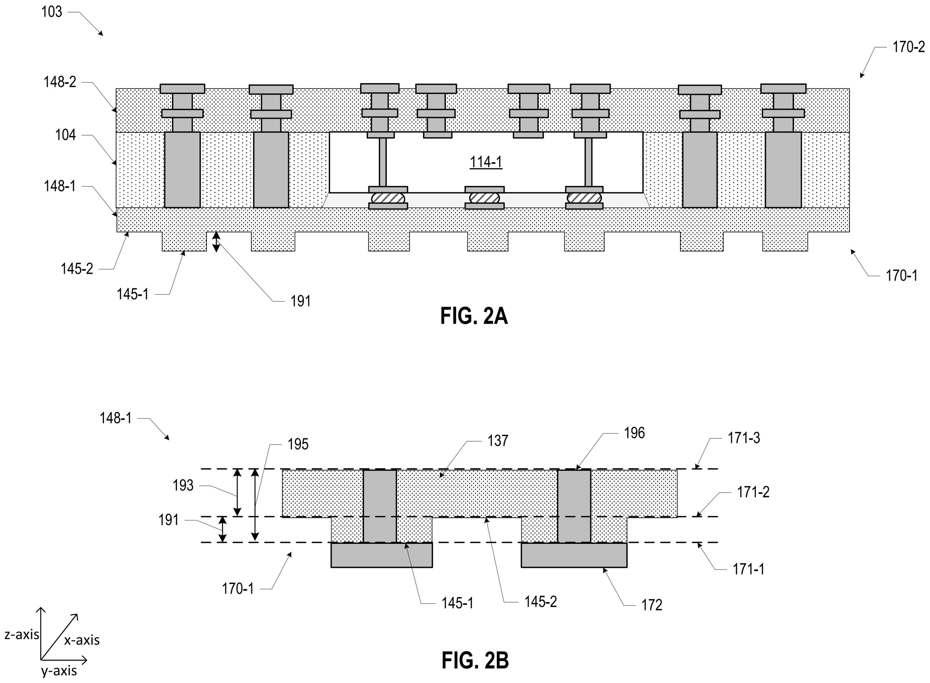

FIG. 2A is a simplified side, cross-sectional view of an example substrate, in accordance with various embodiments. FIG. 2A illustrates the stepped contour of the first major side 170-1 of the substrate 103 (i.e., the bottom surface of the first RDL 148-1) excluding conductive pathways 196 through the first RDL 148-1 and conductive contacts 172. As shown in FIG. 2A, the first major side 170-1 includes a first portion 145-1 and a second portion 145-2, where the first portion 145-1 extends or protrudes out further than the second portion 145-2 by a thickness 191 (e.g., z-dimension) between 3 microns and 10 microns.

FIG. 2B is a magnified side, cross-sectional view of a portion of the substrate of FIG. 2A, in accordance with various embodiments. FIG. 2B shows the first RDL 148-1 of the substrate 103 including conductive pathways 196 and conductive contacts 172. The bottom surface (i.e., the first major side 170-1) of the first RDL 148-1 may include a first portion 145-1 having a surface in a first plane 171-1 and a second portion 145-2 having a surface in a second plane 171-2. The top surface of the first RDL 148-1 may be in a third plane 171-3, where the second plane is between the first plane 171-1 and the third plane 171-3. In some embodiments, a thickness 191 (e.g., z-dimension or distance) between the first plane 171-1 and the second plane 171-2 is between 3 microns and 10 microns. In some embodiments, a thickness 193 between the second plane 171-2 and the third plane 171-3 is between 5 microns and 20 microns. In some embodiments, a thickness 195 between the first plane 171-1 and the third plane 171-3 is between 8 microns and 30 microns. The first portion 145-1 includes a conductive contact 172 on the surface in the first plane 171-1 and conductive pathway 196 through a dielectric material 137 electrically couples to the conductive contact 172.

Returning to FIG. 1, the first layer die 114-1 in layer 104 may include double-sided dies having connections on both surfaces. The first layer dies 114-1 may include conductive contacts 124 at a top surface, conductive contacts 122 at a bottom surface, and TSVs 117. Conductive contacts 122, 124 may have a single pitch or may have a mixed pitch. Conductive contacts 122 at a bottom surface of the first layer die 114-1 may be coupled to the first RDL 148-1 by interconnects 140 and conductive contacts 124 at a top surface of the first layer die 114-1 may be coupled to the second RDL 148-2 by interconnects 125. Interconnects 140, 125 may include any suitable interconnects, for example, solder interconnects, as shown for interconnects 140, metal-metal interconnects, as shown for interconnects 125, or hybrid bonds that include metal-metal bonds and dielectric-dielectric bonds (not shown). In some embodiments, interconnects 140, 125 may have a pitch between 5 microns and 100 microns (e.g., between 5 microns and 25 microns, or between 25 microns and 75 microns). In embodiments having solder interconnects (e.g., interconnects 120, 140, 130), a solder material may include tin; tin and gold; or tin, silver, and copper (e.g., 96.5 % tin, 3% silver, and 0.5% copper). In some embodiments, a solder material may include tin and bismuth (e.g., eutectic tin bismuth) or tin, silver, and bismuth. In some embodiments, a lower-temperature solder may include indium, indium and tin, or gallium.

The second layer dies 114-2 at the second major side 170-2 of the substrate 103 may include conductive contacts 126 on the bottom surface (e.g., single-sided dies). The conductive contacts 126 may have a single pitch or may have a mixed pitch, as shown. In some embodiments, the second layer dies 114-2 may include double-sided dies, for example, to electrically couple to third layer dies (not shown). In some embodiments, the first layer die 114-1 may include an active/passive bridge die (e.g., with or without metal-insulator-metal (MIM) capacitors). In some embodiments, the first layer die 114-1 may enable communications between second layer dies 114-2. In some embodiments, the first layer die 114-1 may include active dies used for computing. In some embodiments, the second layer dies 114-2 may include a central processing unit (CPU)), a graphics processing die (GPU), a system-on-chip die (SOC), an input/output (I/O) die, or a high bandwidth memory (HBM) die.

The first and second RDLs 148-1, 148-2 may include conductive pathways 196 through a dielectric material 137. An RDL 148 may include a dielectric material 137 formed in multiple layers and one or more conductive pathways 196 through the dielectric material 137 (e.g., including conductive vias, as shown, or including conductive traces and/or conductive vias). In some embodiments, the RDL 148 may include multiple layers having a conductive fanout structure. In some embodiments, the dielectric material 137 of the RDL 148 may be composed of bismaleimide triazine (BT) resin, polyimide materials, epoxy materials (e.g., glass reinforced epoxy matrix materials, epoxy build-up films, or the like), mold materials, oxide-based materials (e.g., silicon dioxide or spin on oxide), or low-k and ultra low-k dielectric (e.g., carbon-doped dielectrics, fluorine-doped dielectrics, porous dielectrics, and organic polymeric dielectrics). The RDL 148 may have any suitable thickness and any suitable number of layers. For example, in some embodiments, the first RDL 148-1 may include a single layer with vias having a thickness between 5 microns and 20 microns (e.g., a single passivation layer), and the second RDL 148-2 may include two or more layers with vias and traces with each individual layer having a thickness between 3 microns and 15 microns (e.g., a two layer RDL may have a thickness between 6 microns and 30 microns). In some embodiments, the dielectric material 137 of the first and second RDLs 148-1, 148-2 may be a same material. In some embodiments, the dielectric material 137 of the first and second RDLs 148-1, 148-2 may be different materials. In some embodiments, the conductive pathways 196 through the first and second RDLs 148-1, 148-2 may electrically couple conductive contacts 172 (e.g., on a bottom surface) and conductive contacts 174 (e.g., on a top surface) of the respective first and second RDLs 148-1, 148-2.

The first layer dies 114-1 may be coupled to the second layer dies 114-2 by interconnects 125, by the conductive pathways 196 through the second RDL 148-2, and by interconnects 120. Interconnects 120 may have a single pitch or may have a mixed pitch. In some embodiments, interconnects 120 may have a pitch between 10 microns and 100 microns (e.g., between 10 microns and 25 microns, or between 25 microns and 75 microns). In some embodiments, interconnects 120 may include solder (e.g., solder bumps or balls that are subject to a thermal reflow to form the interconnects 120, as shown). In such embodiments, the microelectronic assembly 100 may further include an underfill material 127 between the bottom surface of the second layer dies 114-2 and the top surface of the second RDL 148-2 around interconnects 120.

The first layer dies 114-1 may be coupled to a package substrate 102 by interconnects 140, by conductive pathways 196 through the first RDL 148-1, and by interconnects 130. The second layer die 114-2 may be coupled to the package substrate 102 by interconnects 120, by conductive pathways through the first and second RDLs 148-1, 148-2, by conductive pillars 152 in the first layer, and by interconnects 130. In some embodiments, the interconnects 130 disclosed herein may have a pitch between 50 microns and 350 microns. In some embodiments, interconnects 130 may include solder and an underfill material 127 may be between the bottom surface of the first RDL 148-1 and a top surface of the package substrate 102 around interconnects 130. In such embodiments, the surface of the second portion 145-2 (e.g., the surface at the second plane 171-2, as shown in FIG. 2B) and the side surface of the first portion 145-1 (e.g., the vertical surface as measured by the thickness 191, as shown in FIG. 2B) are in direct contact with the underfill material 127.

The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering when forming the interconnects 120, 140, 130, and then polymerizes and encapsulates the interconnects 120, 140, 130. The underfill material 127 may be selected to have a CTE that may mitigate or minimize the stress between the dies 114, the RDLs 148, and the package substrate 102 arising from uneven thermal expansion in the microelectronic assembly 100. In some embodiments, the CTE of the underfill material 127 may have a value that is intermediate to the CTE of the package substrate 102 (e.g., the CTE of the dielectric material of the package substrate 102) and a CTE of the dies 114 and/or dielectric material 137 of the RDL 148.

As used herein, a "conductive contact" may refer to a portion of conductive material (e.g., metal) serving as an electrical interface between different components (e.g., part of a conductive interconnect); conductive contacts may be recessed in, flush with, or extending away from a surface of a component, and may take any suitable form (e.g., a conductive pad or socket, or portion of a conductive line or via). Any of the conductive contacts disclosed herein may include bond pads, conductive posts, or any other suitable conductive contact, for example. The die 114 may include other conductive pathways (e.g., including lines and vias) and/or to other circuitry coupled to the respective conductive contacts on the surface of the die 114.

The microelectronic assembly 100 may further include a first insulating material 133-1 around the first layer dies 114-1 and conductive pillars 152, and a second insulating material 133-2 around the second layer dies 114-2. In some embodiments, the insulating material 133 may include an organic material, such as an epoxy-based material with silica fillers, an epoxy composite material with silicone and silica fillers, a polyimide, or a polybenzoxazole. In some embodiments, the insulating material 133 may include a capillary underfill material, a molded underfill material, a mold material, a resin material, an epoxy material, or other inorganic material. In some embodiments, the first insulating material 133-1 and the second insulating material 133-2 are a same material. In some embodiments, the first insulating material 133-1 and the second insulating material 133-2 are different materials.

The conductive pillars 152 may be formed of any suitable conductive material, such as copper, silver, nickel, gold, aluminum, or other metals or alloys, for example. The conductive pillars 152 may be formed using any suitable process, including, for example, a lithographic process or an additive process, such as cold spray or 3-dimensional printing. In some embodiments, the conductive pillars 152 disclosed herein may have a pitch between 50 microns and 150 microns. As used herein, pitch is measured center-to-center (e.g., from a center of a conductive pillar to a center of an adjacent conductive pillar). The conductive pillars 152 may have any suitable size and shape. In some embodiments, the conductive pillars 152 may have a circular, rectangular, or other shaped cross-section. The second layer dies 114-2 may be coupled to the conductive pathways 196 in the RDL 148 and to the conductive pillars 152 in the first layer by metal-metal interconnects (e.g., copper-to-copper interconnects or plated interconnects).

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). The conductive pathways in the dies 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked). In some embodiments, the die 114 may include conductive pathways to route power, ground, and/or signals to/from other dies 114 included in the microelectronic assembly 100. For example, the first layer dies 114-1 may include TSVs 117 or other conductive pathways through which power, ground, and/or signals may be transmitted between the package substrate 102 and the second layer dies 114-2. In some embodiments, the second layer dies 114-2 may couple directly to power and/or ground lines in the package substrate 102 by conductive pillars 152.

The package substrate 102 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 102 may be a dielectric material, such as an organic dielectric material, a fire retardant grade 4 material (FR-4), BT resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 102 is formed using standard printed circuit board (PCB) processes, the package substrate 102 may include FR-4, and the conductive pathways in the package substrate 102 may be formed by patterned sheets of copper separated by build-up layers of the FR-4. The conductive pathways in the package substrate 102 may be bordered by liner materials, such as adhesion liners and/or barrier liners, as suitable. In some embodiments, the package substrate 102 may be formed using a lithographically defined via packaging process. In some embodiments, the package substrate 102 may be manufactured using standard organic package manufacturing processes, and thus the package substrate 102 may take the form of an organic package. In some embodiments, the package substrate 102 may be a set of redistribution layers formed on a panel carrier by laminating or spinning on a dielectric material, and creating conductive vias and lines by laser drilling and plating. In some embodiments, the package substrate 102 may be formed on a removable carrier using any suitable technique, such as a redistribution layer technique. Any method known in the art for fabrication of the package substrate 102 may be used, and for the sake of brevity, such methods will not be discussed in further detail herein.

In some embodiments, the package substrate 102 may be a lower density medium and the die 114 may be a higher density medium or have an area with a higher density medium. As used herein, the term "lower density" and "higher density" are relative terms indicating that the conductive pathways (e.g., including conductive interconnects, conductive lines, and conductive vias) in a lower density medium are larger and/or have a greater pitch than the conductive pathways in a higher density medium. In some embodiments, a higher density medium may be manufactured using a modified semi-additive process or a semi-additive build-up process with advanced lithography (with small vertical interconnect features formed by advanced laser or lithography processes), while a lower density medium may be a PCB manufactured using a standard PCB process (e.g., a standard subtractive process using etch chemistry to remove areas of unwanted copper, and with coarse vertical interconnect features formed by a standard laser process). In other embodiments, the higher density medium may be manufactured using semiconductor fabrication process, such as a single damascene process or a dual damascene process. In some embodiments, additional dies may be disposed on the top surface of the second layer dies 114-2. In some embodiments, additional components may be disposed on the top surface of the second layer dies 114-2. Additional passive components, such as surface-mount resistors, capacitors, and/or inductors, may be disposed on the top surface or the bottom surface of the package substrate 102, or embedded in the package substrate 102.

The microelectronic assembly 100 of FIG. 1 may also include a circuit board (not shown). The package substrate 102 may be coupled to the circuit board by interconnects at the bottom surface of the package substrate 102. The interconnects may include solder balls for a ball grid array arrangement, pins in a pin grid array arrangement or lands in a land grid array arrangement. The circuit board may be a motherboard, for example, and may have other components attached to it. The circuit board may include conductive pathways and other conductive contacts for routing power, ground, and signals through the circuit board, as known in the art. In some embodiments, the package substrate 102 may not be coupled to a circuit board, but instead may couple the package substrate 102 to another IC package, an interposer, or any other suitable component. In some embodiments, the microelectronic assembly 100 may not include a package substrate 102 but instead the layers of dies through the first RDL 148-1 may be electrically coupled to a circuit board.

Although FIG. 1 depicts a microelectronic assembly 100 having a particular number of layers 104 of dies 114 and RDLs 148, this number and arrangement are simply illustrative, and a microelectronic assembly 100 may include any desired number and arrangement of dies 114 and RDLs 148.

Many of the elements of the microelectronic assembly 100 of FIG. 1 are included in other ones of the accompanying drawings; the discussion of these elements is not repeated when discussing these drawings, and any of these elements may take any of the forms disclosed herein. Further, a number of elements are illustrated in FIG. 1 as included in the microelectronic assembly 100, but a number of these elements may not be present in a microelectronic assembly 100. For example, in various embodiments, the underfill material 127 and the package substrate 102 may not be included. In some embodiments, individual ones of the microelectronic assemblies 100 disclosed herein may serve as a system-in-package (SiP) in which multiple dies 114 having different functionality are included. In such embodiments, the microelectronic assembly 100 may be referred to as an SiP.

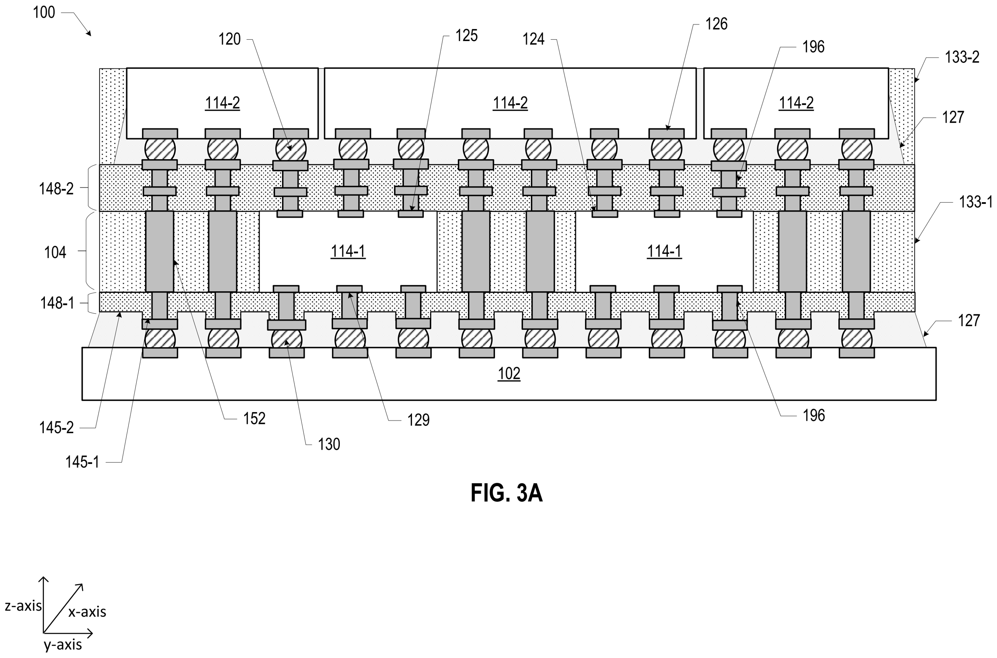

FIG. 3A is a side, cross-sectional view of another example microelectronic assembly, in accordance with various embodiments. The embodiment shown in the figure is similar to that of FIG. 1, except that the layer 104 includes a plurality of first layer die 114-1 and the first layer die 114-1 form solderless metal-metal interconnects 129 with the first conductive pathways 196 in the first RDL 148-1.

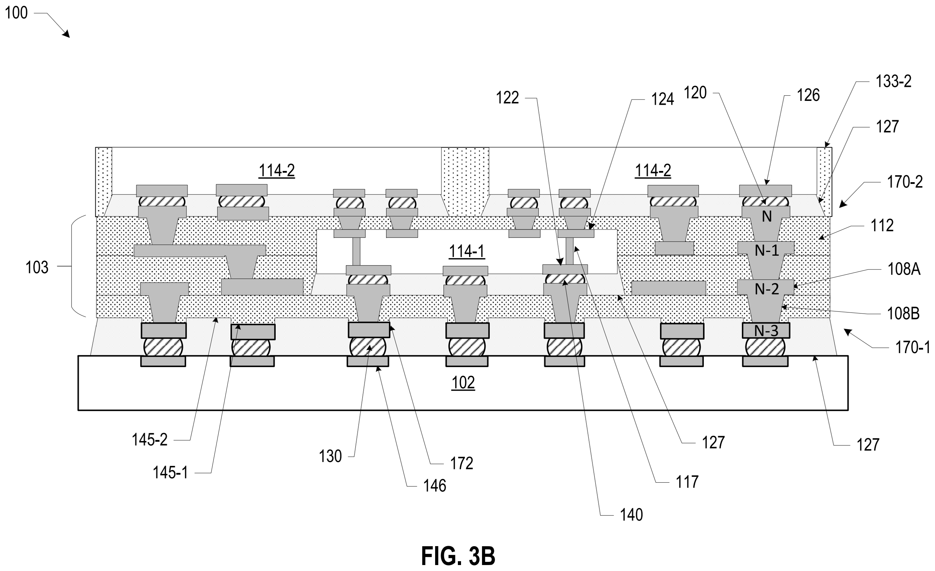

FIG. 3B is a side, cross-sectional view of yet another example microelectronic assembly, in accordance with various embodiments. The microelectronic assembly 100 may include a substrate 103 having a first major side 170-1 having a stepped contour and an opposing second major side 170-2, a package substrate 102 electrically coupled to the first major side 170-1 of the substrate 103, and second layer dies 114-2 electrically coupled to the second major side 170-2 of the substrate 103. As shown in FIG. 3B, the first major side 170-1 includes a first portion 145-1 and a second portion 145-2, where the first portion 145-1 extends or protrudes out further than the second portion 145-2. A microelectronic assembly 100 may include a substrate 103 having N layers of conductive material 108, where N is an integer greater than or equal to one; in the accompanying drawing, the layers are labeled in descending order from the second major side 170-2 to the first major side 170-1 of the substrate 103 (e.g., layer N, layer N-1, layer N-2, layer N-3, etc.). In particular, as shown in FIG. 3B, a substrate 103 may include four metal layers (e.g., N, N-1, N-2, and N-3). A substrate 103 may include a die 114-1 coupled by interconnects 140 to conductive material 108 in the substrate 103, the interconnects 140 may be surrounded by an underfill material 127. The substrate 103 may include a dielectric material 112 and a conductive material 108 (e.g., lines/traces/pads/contacts (e.g., 108A) and vias (e.g., 108B), as shown) around the die 114-1 (e.g., above, below, and along sides of the die 114-1) where the conductive material 108 is arranged in the dielectric material 112 to provide conductive pathways horizontally (e.g., x-direction and y-direction) and vertically (e.g., z-direction) through the substrate 103. As shown in FIG. 3B, the substrate 103 may include layers of dielectric material 112/conductive material 108, with lines/traces/pads/contacts (e.g., 108A) of conductive material 108 in one layer electrically coupled to lines/traces/pads/contacts (e.g., 108A) of conductive material 108 in an adjacent layer by vias (e.g., 108B) of the conductive material 108 extending through the dielectric material 112. In some embodiments, the conductive material 108 may include a metal (e.g., copper). As shown in FIG. 3B, the dielectric material 112 of the substrate 103 may be formed in layers. In some embodiments, the layers of dielectric material 112 may not be distinguishable after formation. In some embodiments, the dielectric material 112 may include an organic dielectric material, such as an organic buildup film, a polyimide, a polyamide, a polyacrylate, an epoxy, a polybenzoxazole, a polyphenyl ether, a polysiloxane, a polynorbornene, or a polyolefin. In some embodiments, the organic dielectric material is photoimageable, such as a photoimageable dielectric (PID), a liquid photoimageable polymer, or a dry film photoimageable polymer. In some embodiments, the dielectric material 112 may include a ceramic, an epoxy film having filler particles therein, glass, an inorganic material, or combinations of organic and inorganic materials, for example. A substrate 103 including such layers may be formed using any suitable technique, for example, conventional package substrate manufacturing techniques.

Any suitable techniques may be used to manufacture the microelectronic assemblies 100 disclosed herein. For example, FIGS. 4A-4K are side, cross-sectional views of various stages in an example process for manufacturing the microelectronic assembly 100 of FIG. 1, specifically, a package side conductive contacts first and second layer die last approach, in accordance with various embodiments. Although the operations discussed below with reference to FIGS. 4A-4K (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 4A-4K may be modified in accordance with the present disclosure to fabricate others of microelectronic assembly 100 disclosed herein.

FIG. 4A illustrates an assembly subsequent to depositing a heat resistant photoresist (HRPR) material 139 on a first carrier 401-1. The first carrier 401-1 may include any suitable material for providing mechanical stability during manufacturing operations, and in some embodiments, may include a semiconductor wafer (e.g., a silicon wafer) or glass (e.g., a glass panel). In some embodiments, a first carrier 401-1 may include a metal layer, such as a copper clad layer (not shown). In some embodiments, a metal seed layer may be deposited prior to depositing the HRPR material 139. An HRPR material 139 may include any suitable material that may withstand manufacturing temperature cycles (i.e., do not degrade) and may be readily removed. In some embodiments, an HRPR material 139 may include, for example, a mixture of acrylic, styrenic, and phenolic polymers with a majority of the composition being phenolic polymers. The HRPR material 139 may be initially deposited on the first carrier 401-1 using any suitable technique (e.g., lamination or spin-on deposition).

FIG. 4B illustrates an assembly subsequent to patterning the HRPR material 139 and forming conductive contact openings 113. The HRPR material 139 may be patterned using any suitable technique, such as a lithographic process (e.g., exposing the HRPR material 139 with a mask to change the solubility of different portions of the photoresist and then etching away the more soluble portions).

FIG. 4C illustrates an assembly subsequent to depositing a conductive material in the openings 113 of FIG. 4B and forming conductive contacts 172. The conductive material may be deposited using any suitable technique, such as an electroplating process, and may include any suitable conductive material, such as copper.

FIG. 4D illustrates an assembly subsequent to depositing a dielectric material 137 on a top surface of the first carrier 401-1 over the HRPR material 139 and conductive contacts 172. The dielectric material 137 may be deposited using any suitable technique, such as lamination or slit coating.

FIG. 4E illustrates an assembly subsequent to forming a first RDL 148-1. The first RDL 148-1 may be formed using any suitable technique, such as a lithography process and a plating process.

FIG. 4F illustrates an assembly subsequent to forming layer 104 on the first RDL 148-1. Conductive pillars 152 and, optionally, conductive contacts 174 may be formed on the first RDL 148-1. First layer die 114-1 may be coupled to the conductive pathways 196 in the first RDL 148-1 by forming interconnects 140, and an underfill material 127 may be deposited around the interconnects 140. The first layer die 114-1 and the conductive pillars 152 may be encapsulated with a first insulating material 133-1 and the top surface of the first insulating material 133-1 may be planarized using any suitable technique, such as chemical mechanical polishing (CMP).

FIG. 4G illustrates an assembly subsequent to forming a second RDL 148-2 on layer 104. The second RDL 148-2 may be manufactured using any suitable technique, such as a lithography process and a plating process. The second RDL 148-2 may include conductive pathways 196 through a dielectric material 137 and conductive contacts 174 on a top surface. The assembly of FIG. 4G may be a multilayered substrate 103 having a first major side 170-1 and a second major side 170-2.

FIG. 4H illustrates an assembly subsequent to electrically coupling second layer die 114-2 on the second major side 170-2 to the conductive pathways 196 in the second RDL 148-2 by forming interconnects 120, depositing an underfill material 127 around the interconnects 120, and encapsulating with a second insulating material 133-2. A top surface of the second insulating material 133-2 may be planarized using any suitable technique, such as CMP.

FIG. 4I illustrates an assembly subsequent to attaching a second carrier 401-2 to a top side of the assembly of FIG. 4H, inverting the assembly, and removing the first carrier 401-1 to expose conductive contacts 172 and the HRPR material 139 at the first major side 170-1.

FIG. 4J illustrates an assembly subsequent to removing the HRPR material 139 from the first major side 170-1 such that the dielectric material 137 of the first RDL 148-1 includes a first portion 145-1 and a second portion 145-2, where the first portion 145-1 extends or protrudes out further than the second portion 145-2.

FIG. 4K illustrates an assembly subsequent to depositing solder 134 on conductive contacts 172, removing the second carrier 401-2, and inverting the assembly. If multiple assemblies are manufactured together, the assemblies may be singulated after removal of the second carrier 401-2. The assembly of FIG. 4K may itself be a microelectronic assembly 100, as shown. Further manufacturing operations may be performed on the microelectronic assembly 100 of FIG. 4K to form other microelectronic assembly 100; for example, the solder 134 may be used to couple the microelectronic assembly 100 of FIG. 4K to a package substrate 102 via interconnects 130, and an underfill material 127 may be deposited around interconnects 130, similar to the microelectronic assembly 100 of FIG. 1.

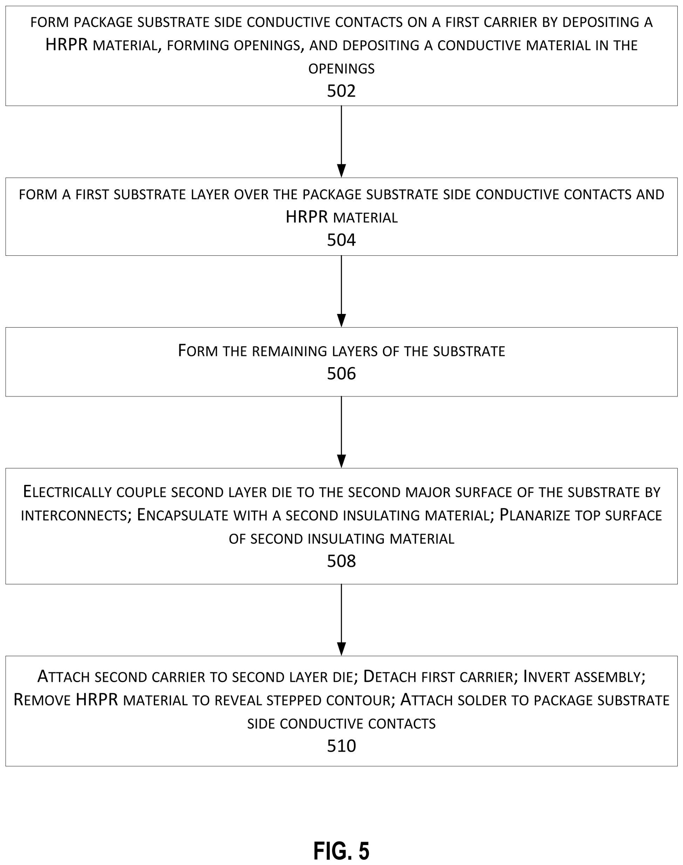

FIG. 5 is a flow diagram of an example method of fabricating an example microelectronic assembly, in accordance with various embodiments. The example method described with respect to FIG. 5 includes forming package substrate side conductive contacts 172 first by using an HRPR material 139 to protect the conductive contacts 172 during manufacturing of the microelectronic assembly 100. At 502, package substrate side conductive contacts 172 may be formed on a first carrier 401-1 by depositing an HRPR material 139, forming openings, and depositing a conductive material in the openings. At 504, a first layer of a substrate 103 may be formed over the package substrate side conductive contacts 172 and the HRPR material 139. The first layer of the substrate 103 may include, for example, conductive pathways 196 through a dielectric material 137 electrically coupled to the package substrate side conductive contacts 172 (e.g., as shown for the first RDL 148-1 in FIG. 1 or 3A) or may include a conductive material 108 through a dielectric material 112 electrically coupled to the package substrate side conductive contacts 172 (e.g., as shown for first layer of the substrate 103 in FIG. 3B). At 506, form the remaining layers of the substrate 103. At 508, electrically coupled second layer die 114-2 to the second major side 170-2 of the substrate 103 by interconnects 120, and deposit an underfill material 127 around the interconnects 120. A second insulating material 133-2 may be deposited on and around the second layer die 114-2 and planarized. At 510, a second carrier 401-2 may be attached to the second layer die 114-2, the first carrier 401-1 may be removed, the assembly may be inverted, the HRPR material 139 may be removed to reveal the stepped contour of the first major side 170-1, and solder 134 may be deposited on package substrate side conductive contacts 172. Further manufacturing operations may be performed on the microelectronic assembly; for example, the solder 134 may be used to couple the microelectronic assembly 100 to a package substrate 102 via interconnects 130, similar to the microelectronic assembly 100 of FIG. 1, 3A, or 3B.

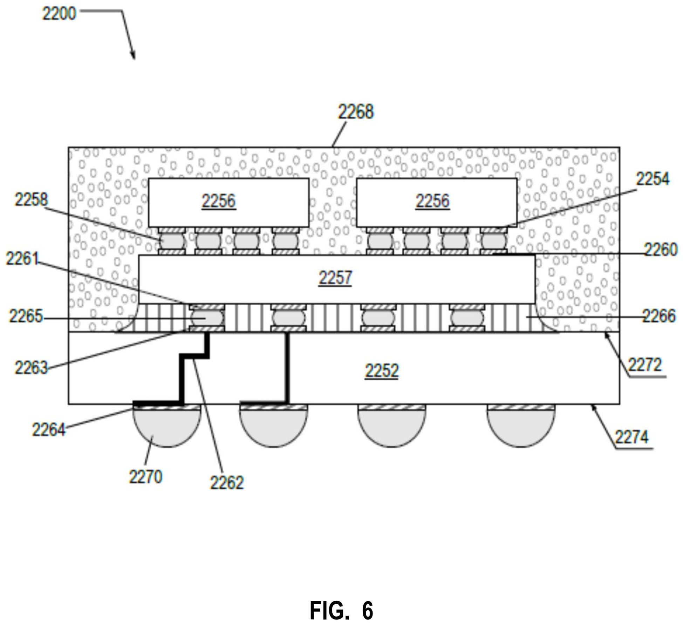

The packages disclosed herein, e.g., any of the embodiments shown in FIGS. 1-4 or any further embodiments described herein, may be included in any suitable electronic component. FIGS. 6-8 illustrate various examples of packages, assemblies, and devices that may be used with or include any of the IC packages as disclosed herein.

FIG. 6 is a side, cross-sectional view of an example IC package 2200 that may include IC packages in accordance with any of the embodiments disclosed herein. In some embodiments, the IC package 2200 may be a SiP.

As shown in the figure, package substrate 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures including lines and/or vias.

Package substrate 2252 may include conductive contacts 2263 that are coupled to conductive pathway 2262 through package substrate 2252, allowing circuitry within dies 2256 and/or interposer 2257 to electrically couple to various ones of conductive contacts 2264 (or to other devices included in package substrate 2252, not shown).

IC package 2200 may include interposer 2257 coupled to package substrate 2252 via conductive contacts 2261 of interposer 2257, first-level interconnects 2265, and conductive contacts 2263 of package substrate 2252. First-level interconnects 2265 illustrated in the figure are solder bumps, but any suitable first-level interconnects 2265 may be used, such as solder bumps, solder posts, or bond wires.

IC package 2200 may include one or more dies 2256 coupled to interposer 2257 via conductive contacts 2254 of dies 2256, first-level interconnects 2258, and conductive contacts 2260 of interposer 2257. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). First-level interconnects 2258 illustrated in the figure are solder bumps, but any suitable first-level interconnects 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

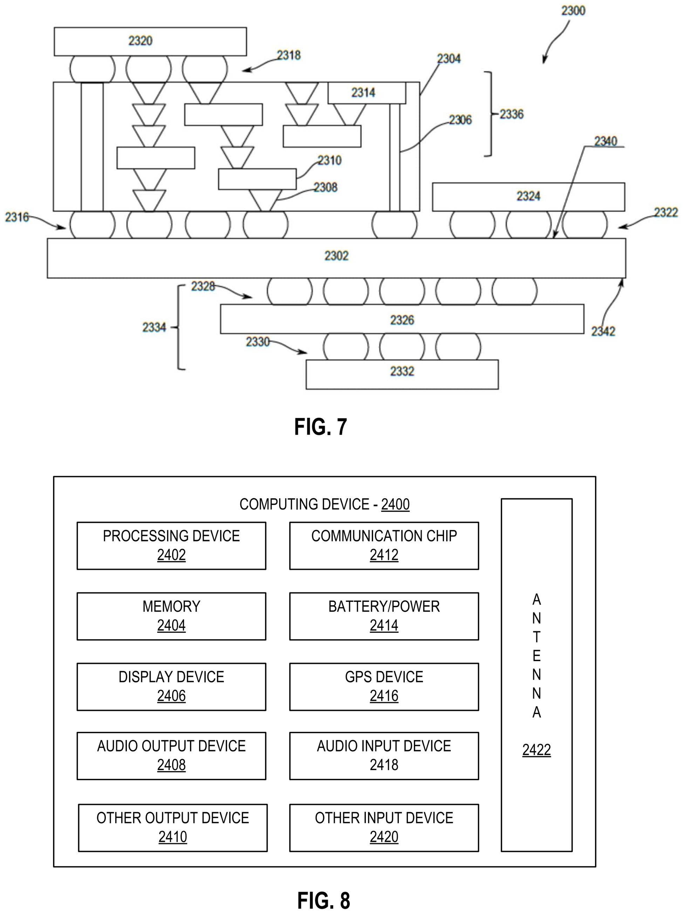

In some embodiments, underfill material 2266 may be disposed between package substrate 2252 and interposer 2257 around first-level interconnects 2265, and mold 2268 may be disposed around dies 2256 and interposer 2257 and in contact with package substrate 2252. In some embodiments, underfill material 2266 may be the same as mold 2268. Example materials that may be used for underfill material 2266 and mold 2268 are epoxies as suitable. Second-level interconnects 2270 may be coupled to conductive contacts 2264. Second-level interconnects 2270 illustrated in the figure are solder balls (e.g., for a ball grid array (BGA) arrangement), but any suitable second-level interconnects 2270 may be used (e.g., pins in a pin grid array arrangement or lands in a land grid array arrangement). Second-level interconnects 2270 may be used to couple IC package 2200 to another component, such as a circuit board (e.g., a motherboard), an interposer, or another IC package, as known in the art and as discussed below with reference to FIG. 7.

In embodiments in which IC package 2200 includes multiple dies 2256, IC package 2200 may be referred to as a multi-chip package (MCP). Dies 2256 may include circuitry to perform any desired functionality. For example, besides one or more of dies 2256 being microelectronic assembly 100 as described herein, one or more of dies 2256 may be logic dies (e.g., silicon-based dies), one or more of dies 2256 may be memory dies (e.g., HBM), etc. In some embodiments, any of dies 2256 may be implemented as discussed with reference to any of the previous figures. In some embodiments, at least some of dies 2256 may not include implementations as described herein.

Although IC package 2200 illustrated in the figure is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package substrate 2252, or on either face of interposer 2257. More generally, IC package 2200 may include any other active or passive components known in the art.

In some embodiments, no interposer 2257 may be included in IC package 2200; instead, dies 2256 may be coupled directly to conductive contacts 2263 at first face 2272 by first-level interconnects 2265.

FIG. 7 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; e.g., any of the IC packages discussed below with reference to IC device assembly 2300 may take the form of any of the embodiments of IC package 2200 discussed above with reference to FIG. 6.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package substrate.

As illustrated in the figure, in some embodiments, IC device assembly 2300 may include a package-on-interposer structure 2336 coupled to first face 2340 of circuit board 2302 by coupling components 2316. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. Coupling components 2318 may take any suitable form depending on desired functionalities, such as the forms discussed above with reference to coupling components 2316. In some embodiments, IC package 2320 may be or include IC package 2200, e.g., as described above with reference to FIG. 6.

Although a single IC package 2320 is shown in the figure, multiple IC packages may be coupled to interposer 2304; indeed, additional interposers may be coupled to interposer 2304. Interposer 2304 may provide an intervening package substrate used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in the figure, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass-reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2310 and vias 2308, including but not limited to TSVs 2306. Interposer 2304 may further include embedded devices 2314, including both passive and active devices. Such devices may include, but are not limited to, capacitors, decoupling capacitors, resistors, inductors, fuses, diodes, transformers, sensors, ESD devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 8 is a block diagram of an example computing device 2400 that may include one or more components having one or more IC packages in accordance with any of the embodiments disclosed herein. For example, any suitable ones of the components of computing device 2400 may include a microelectronic assembly 100 in accordance with any of the embodiments disclosed herein. In another example, any one or more of the components of computing device 2400 may include any embodiments of IC package 2200 (e.g., as shown in FIG. 6). In yet another example, any one or more of the components of computing device 2400 may include an IC device assembly 2300 (e.g., as shown in FIG. 7).

A number of components are illustrated in the figure as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single system-on-chip (SOC) die.

Additionally, in various embodiments, computing device 2400 may not include one or more of the components illustrated in the figure, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more DSPs, ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid-state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), LTE project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

The descriptions of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 provides a substrate for a multi-die package, the substrate including a dielectric material having a first surface and an opposing second surface, where the first surface includes a protruding portion; a conductive contact on the protruding portion of the first surface of the dielectric material; and a conductive pathway through the dielectric material and coupled to the conductive contact.

Example 2 provides the substrate of example 1, where the protruding portion of the first surface of the dielectric material has a thickness between 3 microns and 10 microns.

Example 3 provides the substrate of example 1 or 2, further including a package substrate coupled to the conductive contact by an interconnect.

Example 4 provides the substrate of example 3, where the interconnect includes solder.

Example 5 provides the substrate of example 4, further including an underfill material between the first surface of the dielectric material and the package substrate, and surrounding the interconnect.

Example 6 provides the substrate of any one of examples 1-5, where the protruding portion of the first surface of the dielectric material is one of a plurality of protruding portions.

Example 7 provides the substrate of any one of examples 1-6, where the dielectric material is a first dielectric material and the conductive pathway is a first conductive pathway, and the substrate further including a die surrounded by an insulating material on the second surface of the first dielectric material, where the first conductive pathway is coupled to the die; a second dielectric material on the die and the insulating material; and a second conductive pathway through the second dielectric material coupled to the die.

Example 8 provides the substrate of example 7, further including conductive pillars through the insulating material.

Example 9 provides the substrate of example 7 or 8, where the die includes through-silicon vias (TSVs).

Example 10 provides an integrated circuit (IC) package, including a substrate having a first major side and a second major side opposite the first major side, where the first major side includes a first portion having a surface in a first plane and a second portion having a surface in a second plane different than the first plane, and where a distance between the first plane and the second plane is between 3 microns and 10 microns; and a conductive contact on the first portion of the first major side; and a package substrate, at the first major side, coupled to the conductive contact.

Example 11 provides the IC package of example 10, where the package substrate is coupled to the conductive contact by an interconnect including solder.

Example 12 provides the IC package of example 11, further including an underfill material between the first major side of the substrate and the package substrate surrounding the interconnect.

Example 13 provides the IC package of any one of examples 10-12, where the substrate includes a plurality of layers, and the substrate further including a first layer including first conductive pathways through a first dielectric material, the first layer having the first major side as a first surface and an opposing second surface; a second layer on the second surface of the first layer, the second layer including dies surrounded by an insulating material, where individual dies are coupled to one or more of the first conductive pathways by first interconnects; and a third layer, on the second layer, the third layer including second conductive pathways through a second dielectric material, where individual dies are coupled to one or more of the second conductive pathways by second interconnects.

Example 14 provides the IC package of example 13, further including conductive pillars through the insulating material.

Example 15 provides the IC package of example 13 or 14, where the dies include through-silicon vias (TSVs).

Example 16 provides the IC package of any one of examples 13-15, where the first interconnects include solder.

Example 17 provides the IC package of any one of examples 13-16, where the second interconnects include metal-metal interconnects.

Example 18 provides the IC package of any one of examples 13-17, where the dies are first dies surrounded by a first insulating material, and the IC package further including second dies, on the third layer, surrounded by a second insulating material, where individual second dies are coupled to the second conductive pathways by third interconnects.

Example 19 provides the IC package of example 18, where the third interconnects include solder.

Example 20 provides the IC package of any one of examples 10-19, where the first portion is one of a plurality of first portions.

Example 21 provides a microelectronic assembly, including a first redistribution layer (RDL) having first conductive pathways through a first dielectric material, the first RDL having a first surface and an opposing second surface, where the first surface includes a first portion having a first thickness, a second portion having a second thickness less than the first thickness; and a conductive contact, on the first portion of the first surface, coupled to at least one of the first conductive pathways; a first die, on the second surface of the first RDL, surrounded by a first insulating material, where the first die is coupled to one or more of the first conductive pathways by first interconnects; a second RDL on the first die and first insulating material, the second RDL including second conductive pathways through a second dielectric material, where first die is coupled to one or more of the second conductive pathways by second interconnects; and a second die, on the second RDL, surrounded by a second insulating material, where the second die is coupled to the second conductive pathways by third interconnects.

Example 22 provides the microelectronic assembly of example 21, where the first thickness is greater than the second thickness by between 3 microns and 10 microns.

Example 23 provides the microelectronic assembly of example 21 or 22, further including a package substrate coupled to the conductive contact by a fourth interconnect.

Example 24 provides the microelectronic assembly of example 23, where the fourth interconnect includes solder.

Example 25 provides the microelectronic assembly of example 23 or 24, further including an underfill material between the first surface of the first dielectric material and the package substrate, and surrounding the fourth interconnect.

Example 26 provides the microelectronic assembly of any one of examples 21-25, where the first portion is one of a plurality of first portions.

## Claims

1. A substrate for a multi-die package, the substrate comprising:
a dielectric material having a first surface and an opposing second surface, wherein the first surface includes a protruding portion;
a conductive contact on the protruding portion of the first surface of the dielectric material; and
a conductive pathway through the dielectric material and coupled to the conductive contact.

2. The substrate of claim 1, wherein the protruding portion of the first surface of the dielectric material has a thickness between 3 microns and 10 microns.

3. The substrate of one of the previous claims, further comprising:
a package substrate coupled to the conductive contact by an interconnect.

4. The substrate of claim 3, wherein the interconnect includes solder.

5. The substrate of one of the previous claims, wherein the protruding portion of the first surface of the dielectric material is one of a plurality of protruding portions.

6. The substrate of one of the previous claims, wherein the dielectric material is a first dielectric material and the conductive pathway is a first conductive pathway, and the substrate further comprising:
a die surrounded by an insulating material on the second surface of the first dielectric material, wherein the first conductive pathway is coupled to the die;
a second dielectric material on the die and the insulating material; and
a second conductive pathway through the second dielectric material coupled to the die.

7. The substrate of claim 6, further comprising:
conductive pillars through the insulating material.

8. An integrated circuit (IC) package, comprising:
a substrate, comprising:
a first major side and a second major side opposite the first major side, wherein the first major side includes a first portion having a surface in a first plane and a second portion having a surface in a second plane different than the first plane, and wherein a distance between the first plane and the second plane is between 3 microns and 10 microns; and
a conductive contact on the first portion of the first major side; and
a package substrate, at the first major side, coupled to the conductive contact.

9. The IC package of claim 8, wherein the package substrate is coupled to the conductive contact by an interconnect including solder.

10. The IC package of claim 8 or 9, wherein the substrate includes a plurality of layers, and the substrate further comprising:
a first layer including first conductive pathways through a first dielectric material, the first layer having the first major side as a first surface and an opposing second surface;
a second layer on the second surface of the first layer, the second layer including dies surrounded by an insulating material, wherein individual dies are coupled to one or more of the first conductive pathways by first interconnects; and
a third layer, on the second layer, the third layer including second conductive pathways through a second dielectric material, wherein individual dies are coupled to one or more of the second conductive pathways by second interconnects.

11. The IC package of claim 10, wherein the dies are first dies surrounded by a first insulating material, and the IC package further comprising:
second dies, on the third layer, surrounded by a second insulating material, wherein individual second dies are coupled to the second conductive pathways by third interconnects.

12. A microelectronic assembly, comprising:
a first redistribution layer (RDL) including first conductive pathways through a first dielectric material, the first RDL having a first surface and an opposing second surface, wherein the first surface includes:
a first portion having a first thickness,
a second portion having a second thickness less than the first thickness; and
a conductive contact, on the first portion of the first surface, coupled to at least one of the first conductive pathways;
a first die, on the second surface of the first RDL, surrounded by a first insulating material, wherein the first die is coupled to one or more of the first conductive pathways by first interconnects;
a second RDL on the first die and first insulating material, the second RDL including second conductive pathways through a second dielectric material, wherein first die is coupled to one or more of the second conductive pathways by second interconnects; and
a second die, on the second RDL, surrounded by a second insulating material, wherein the second die is coupled to the second conductive pathways by third interconnects.

13. The microelectronic assembly of claim 12, wherein the first thickness is greater than the second thickness by between 3 microns and 10 microns.

14. The microelectronic assembly of claim 12 or 13, further comprising:
a package substrate coupled to the conductive contact by a fourth interconnect, wherein the fourth interconnect includes solder.

15. The microelectronic assembly of claim 14, further comprising:
an underfill material between the first surface of the first dielectric material and the package substrate, and surrounding the fourth interconnect.
